# EUROPEAN PATENT APPLICATION

(11) **EP 1 591 554 A1**
(43) Date of publication of application: **02.11.2005**
(21) Application number: 04704353.4
(22) Date of filing: 22.01.2004
(51) Int. Cl.: C23C 14/08, H01B 5/14

(54) **ITO THIN FILM, FILM-FORMING METHOD OF SAME, TRANSPARENT CONDUCTIVE FILM AND TOUCH PANEL**

(30) Priority: 24.01.2003 JP 2003016305; 11.03.2003 JP 2003065264
(71) Applicant: Bridgestone Corporation, Tokyo 104-8340 (JP)
(72) Inventor: OHNO, Shingo, Bridgestone Corporation, Kodaira-shi, Tokyo 187-0031 (JP); IWABUCHI, Yoshinori, Bridgestone Corporation, Kodaira-shi, Tokyo 187-0031 (JP); YOSHIKAWA, Masato, Bridgestone Corporation, Kodaira-shi, Tokyo 187-0031 (JP); SHIGESATO, Yuzo, Aoyama Gakuin University, Setagaya-ku, Tokyo 157-0071 (JP); KON, Masato, Aoyama Gakuin University, Setagaya-ku, Tokyo 157-0071 (JP)
(74) Representative: Whalley, Kevin
(86) International application number: PCT/JP2004/000527
(87) International publication number: WO 2004/065656

(57) **Abstract**

A crystalline ITO transparent conductive thin film is formed by heating a substrate at low temperature during the sputtering film formation. The crystalline ITO transparent conductive thin film is formed by using an ITO target comprising In₂O₃ and SnO₂ where a weight percentage of SnO₂ is 6% or less based on the total weight of In₂O₃ and SnO₂ in the ITO target, and heating the substrate at 90 to 170°C during the sputtering film formation. The crystalline ITO film with high strength and mechanical durability can be formed by heating at low temperature, which meets heat resistance of the substrate, without requiring annealing after the film formation. There are provided a transparent conductive film comprising a polymer film 4 and an ITO transparent conductive film 5 formed thereon, and a touch panel comprising the transparent conductive film.

## Description

### Technical Field

The present invention relates to a method of producing an ITO thin film, and the ITO thin film. More particularly, the present invention relates to a method of producing an ITO thin film using an In/Sn alloy target, and the ITO thin film produced by the method.

The present invention relates to a method of producing a crystalline ITO transparent conductive thin film having high strength and mechanical durability with high productivity and low costs by heating a substrate at relatively low temperature for crystallization that meets heat resistance of the substrate during the sputtering film formation, without requiring annealing after the film formation. The present invention relates to a thus-formed crystalline ITO transparent conductive thin film, a transparent conductive film comprising a polymer film and the crystalline ITO transparent conductive thin film formed thereon, and a touch panel having the transparent conductive film.

### Background Art

ITO (Indium Tin Oxide) thin films have high conductivity and transparency, are easily subjected to micromachining, and therefore are used in various fields as a display electrode for a flat panel display, a window material for a solar cell, an electrode for a touch panel and an antistatic film. Especially, in the flat panel display art including a crystal display device, the needs of upsizing and high-density are increasing. The use of the ITO thin film as the display electrode rapidly grows in demand.

The method of producing the ITO thin film can be roughly classified into a chemical film forming method such as a spray thermal decomposition method and a CVD method; and a physical film forming method such as an electron beam vapor deposition method and a sputtering method. Particularly, the sputtering method is widely utilized, because a large surface area can be easily attained and a high performance film can be provided.

When the ITO thin film is produced by the sputtering method, an ITO sintered target where a mixture of indium oxide and tin oxide is sintered is generally used.

However, the manufacturing costs of the ITO sintered target are high, because a multiple oxide is sintered. The expensive target increases in turn the manufacturing costs of the ITO thin film.

A resistance film type touch panel into which a signal is inputted by pressing with a finger or drawing with a dedicated pen, contacting with a counter electrode and energizing is advantageously compact and light-weight, has a reduced thickness, and is widely used as an input device for various household electric appliances and mobile terminals.

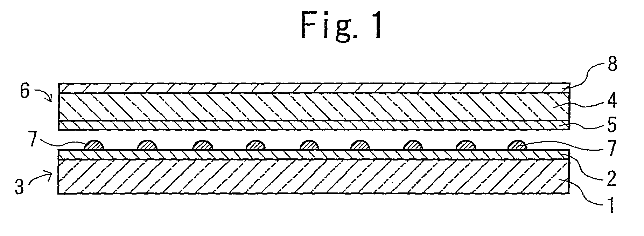

As shown in Fig. 1, the resistance film type touch panel comprises a lower electrode 3 comprising a glass plate 1 and an ITO transparent conductive thin film 2 formed thereon, an upper electrode 6 comprising a polymer film 4 and an ITO transparent conductive thin film 5 formed thereon, and a spacer (micro dot spacer) 7 sandwiched between the ITO transparent conductive thin films 2 and 5 facing each other. When a display surface of the upper electrode 6 is pressed with a finger or a pen, the upper electrode 6 is contacted with the lower electrode 3 to energize, whereby a signal is inputted. A hard coat layer 8 is disposed on the surface of the upper electrode 6 in order to protect the polymer film 4.

Conventionally, the ITO transparent conductive thin films 2 and 3 of the touch panel are generally formed by a DC sputtering.

In the touch panel, in response to the input by a finger or a pen, the ITO transparent conductive thin film 5 of the upper electrode 6 and the ITO transparent conductive thin film 2 of the lower electrode 3 are repeatedly contacted and non-contacted. A transparent conductive material such as ITO (indium tin oxide) for forming the ITO transparent conductive thin films 5 and 2 has low abrasion resistance. Accordingly, the ITO transparent conductive thin film 5 of the upper electrode 6 that is subjected to deformation repeatedly upon the input to the touch panel is more easily cracked than the ITO transparent conductive thin film 2. The ITO transparent conductive thin film 5 is easily peeled and dropped from the polymer film 4, i.e., the substrate, upon the contact and non-contact of the ITO transparent conductive thin films 2 and 5 comprising the same material.

If the ITO transparent conductive thin film 5 of the upper electrode 6 is damaged or peeled, an electrical resistance value on the surface of the ITO transparent conductive thin film 5 is changed, its uniformity is also lost to deteriorate electrical properties, and a correct input cannot be conducted.

Japanese Unexamined Patent Application Publication No. 2-194943 describes that an ITO film is formed, and thermally processed (annealed) to crystallize ITO in order to enhance durability of a transparent conductive film for use in a touch panel. In the case of forming an ITO film on a resin substrate such as a polymer film by sputtering, the resultant ITO transparent conductive thin film is amorphous, since the substrate cannot be heated during the film formation. The amorphous film has low strength, and cannot be used for the application which demands mechanical durability. Accordingly, in the method described in the Patent Application, the resultant ITO film is annealed and crystallized to enhance the film strength.

When the ITO film is annealed, the annealing temperature cannot be increased because the substrate of the transparent conductive film is the polymer film. The annealing should be conducted at relatively low temperature for prolonged time, for example, at 150°C for 24 hours.

In contrast, if an ITO film having transparency and conductivity can be formed as deposited by sputtering and be crystallized during the film formation, no annealing is needed after the film formation, thereby significantly improving the productivity and reducing the costs.

### Disclosure of Invention

A first object of the present invention is to solve the above-mentioned problems in the prior art, and to provide a method of effectively producing an ITO thin film with low costs.

A first aspect of the present invention for achieving the first object is a method of producing an ITO thin film comprising the step of forming the ITO thin film by a reactive sputtering using an In/Sn alloy target.

According to the first aspect, the ITO thin film is formed by the reactive sputtering using an inexpensive In/Sn alloy target (hereinafter sometimes referred to as "IT target"), whereby the ITO thin film can be produced at low costs.

The ITO thin film has different conductivity depending on its oxidation degree. In order to form the ITO thin film having good conductivity, the ITO thin film should have a predetermined oxidation degree. When the ITO thin film is formed by the reactive sputtering using the IT target, it is extremely difficult to control the oxidation degree of the ITO thin film formed.

In the first aspect, an oxygen concentration under a sputter atmosphere is simply controlled by a plasma emission control or a plasma impedance control, thereby forming a high conductive ITO thin film having a desired oxidation degree.

A plurality of cathodes are disposed on which the targets are disposed, and a voltage is intermittently applied to each cathode to conduct the reactive sputtering, whereby the film can be formed stably at higher speed for a prolonged period.

A second object of the present invention is to solve the above-mentioned problems in the prior art, to provide a method of producing a crystalline ITO transparent conductive thin film having high strength and mechanical durability with high productivity and low costs by heating a substrate at relatively low temperature for crystallization that meets heat resistance of the substrate during the sputtering film formation, without requiring annealing after the film formation, and to further provide a thus-formed crystalline ITO transparent conductive thin film, a transparent conductive film comprising a polymer film and the crystalline ITO transparent conductive thin film formed thereon, and a touch panel having the transparent conductive film.

A second aspect of the present invention for achieving the second object is a method of producing an ITO transparent conductive thin film on a substrate by a sputtering method, wherein a crystalline ITO transparent conductive thin film is formed by using an ITO target comprising In₂O₃ and SnO₂ where a weight percentage of SnO₂ is 6% or less based on the total weight of In₂O₃ and SnO₂ in the ITO target, and heating the substrate at 90 to 170°C during the sputtering film formation.

A third aspect of the present invention is an ITO transparent conductive thin film produced on a substrate by a sputtering method, wherein a crystalline ITO transparent conductive thin film is formed by using an ITO target comprising In₂O₃ and SnO₂ where a weight percentage of SnO₂ is 6% or less based on the total weight of In₂O₃ and SnO₂ in the ITO target, and heating the substrate at 90 to 170°C during the sputtering film formation.

Hereinafter, a weight percentage of SnO₂ on the total weight of In₂O₃ and SnO₂ in the ITO target is sometimes referred to as "SnO₂ percentage."

In a typical high density ITO target for forming the ITO thin film by the sputtering, the SnO₂ percentage is 10%. This is because In is difficult to be substituted with Sn when the crystallized ITO thin film is formed as deposited by heating a glass substrate upon the sputtering. Also, when the SnO₂ percentage is increased, an acid- or alkali-resistant film is provided. The reason why the SnO₂ percentage is about 10% is that a high density target is advantageously produced.

However, when the substrate is made of a polymer material, the substrate cannot be heated at high temperature during the film formation and the resultant ITO thin film becomes amorphous. The 10% of Sn does not substitute In, does not contribute to the production of the conductivity (carrier), and rather constitutes a scattering center to inhibit the conductivity. It is assumed that the Sn in the ITO thin film that inhibits the conductivity also inhibit the crystallization, which is performed as deposited by heating the substrate. Especially when the thin film having a thickness of 40 nm or less, the crystalline ITO film is not formed even if the substrate is heated.

It is found that the crystallization can be performed even if the substrate is heated at low temperature by changing the SnO₂ percentage in the ITO target and decreasing the SnO₂ percentage.

Specifically, the thin film having a thickness of 40 nm formed on the heated substrate by using the conventional ITO target containing 10% of SnO₂ is amorphous. In contrast, when the ITO target containing 6% or less of SnO₂ is used to form a thin film by heating the substrate at low temperature of 90 to 170°C with sputtering, the thin film is a crystalline film, though it has a thickness of 40 nm or less.

The second and third aspects are effective for the substrate made of the polymer material that cannot be heated at high temperature, and are also effective for the ITO film having the thickness of 40 nm or less that cannot be crystallized using the conventional TIO target.

It is preferable that the ITO target contain 1 to 5% of SnO₂ in the second and third aspects.

A fourth aspect is a transparent conductive film comprising an ITO transparent conductive thin film formed on a polymer film. The ITO transparent conductive thin film has excellent mechanical durability.

According to the transparent conductive film, an underlayer may be disposed between the polymer film and the ITO transparent conductive thin film, whereby the ITO transparent conductive thin film can be more tightly contacted with the polymer film.

A fifth aspect is a touch panel comprising the transparent conductive film. Since the ITO transparent conductive thin film has a good mechanical durability, the touch panel has excellent sliding resistance upon the input.

### Brief Description of the Drawings

Fig. 1 is a sectional view showing a structure of general touch panel.

### Best Mode for Carrying Out the Invention

A preferable mode according to the first aspect will be described below in detail.

In the first aspect, an IT target is used for a reactive sputtering. The IT target has a In/Sn alloy composition corresponding to the In/Sn composition of the resultant ITO thin film. In general, the IT target preferably contains 50 to 99% by weight, more preferably 85 to 97% by weight of In, and the balance of substantially Sn. It is preferable that the IT target have high purity and contain 0.1% by weight or less, more preferably 0.01% by weight or less of impurities in order to improve the properties of the resultant ITO thin film.

Using the IT target, the reactive sputtering is conducted under atmosphere gas that a predetermined amount of oxygen gas introduced into a noble gas such as Ar. It is preferable that the oxygen content in the atmosphere gas be controlled so that the ITO thin film having the desired oxidation degree is formed.

The oxygen content in the atmosphere depends on the total pressure within the chamber and other sputtering conditions such as a pumping speed, and is difficult to be defined indiscriminately. For example, when the ITO thin film to be formed has the oxydation degree of 95 to 100, excellent conductivity is obtained. It is therefore preferable that the oxygen content in the sputtering atmosphere be controlled so that the ITO thin film having such oxydation degree is formed.

The oxygen content in the sputtering atmosphere can be easily controlled by a plasma emission control or a plasma impedance control. Specifically, light emission intensity of oxygen, In or Sn is monitored in a plasma, and the result is fedback to control an opening of a valve for controlling oxygen gas flow rate. Alternatively, a voltage or a current value upon sputtering is monitored, and the result is fedback to control the opening of the valve for controlling the oxygen gas flow rate.

Upon the formation of the ITO thin film, a plurality of cathodes, i.e., dual cathodes, are used, IT targets are set to each of the two cathodes disposed side by side, and a voltage is preferably applied to the cathodes alternately to conduct the reactive sputtering, whereby the film can be formed more rapidly.

According to the first aspect, the reactive sputtering conditions are not especially limited, but are preferably the followings:
Pressure : 0.3 to 1.0 Pa
Atmosphere : Ar +O₂, O₂ flow ratio of 3 to 20%

When the dual cathodes are used, a frequency of the voltage applied alternately is preferably about 10 to 80 kHz.

A thickness of the thus-formed ITO thin film is determined by its application as required, and is generally about 200 to 800 nm. If the thickness is thinner than the range, the conductivity is insufficient. If the thickness is thicker than the range, the device becomes undesirably thick.

The substrate on which the ITO thin film is formed include a glass and various organic resin films. Examples of the organic resin film include films of polyester, polyethylene terephthalate (PET), polybutylene terephthalate, polymethyl methacrylate (PMMA), acryl, polycarbonate (PC), polyimide (PI), polystyrene, triacetate (TAC), polyvinyl alcohol, polyvinyl chloride, polyvinylidene chloride, polyethylene, ethylene - vinyl acetate copolymer, polyvinyl butyral, metal ion-crosslinked ethylene - methacrylic acid copolymer, polyurethane, cellophane and the like. From a strength standpoint, the PET, PC, PMMA or TAC film is preferable, and the PET or TAC film is especially preferable.

The following examples illustrate the first aspect in detail.

### EXAMPLES 1 to 3

Using the IT target described below, an ITO thin film having a thickness of 500 nm was formed on a glass substrate by a reactive sputtering under the following conditions. The reactive sputtering was conducted by setting the IT target on a single cathode of a magnetron DC sputtering apparatus.

### [ IT target]

In content : 95% by weight
Sn content : substantially the balance
Impurities : 0.01% by weight or less
[Reactive sputtering conditions]
Pressure : 0.7 Pa
Power : 0.5 kW

Upon the reactive sputtering, an O₂ flow ratio in the Ar +O₂ atmosphere was controlled to the value shown in TABLE 1 by a plasma emission control or a plasma impedance control. A film forming speed (a film thickness formed per unit time) was measured, and the results are shown in TABLE 1. The conductivity of the resultant ITO thin film was measured by the Funderpauw method, and the results are shown in TABLE 1.

### EXAMPLES 4 to 6

An ITO thin film was formed as in EXAMPLES 1 to 3 except that two IT targets were set on dual cathodes of a magnetron DC sputtering apparatus and the reactive sputtering was conducted under the following conditions. A film forming speed and the conductivity were measured, and the results are shown in TABLE 1.

### [Reactive sputtering conditions]

Pressure : 0.7 Pa
Power : 0.5 kW (x2)
Frequency of voltage applied by dual cathodes : 50 kHz

**TABLE 1**

| Example | Cathode type | O₂ flow ratio under the atmosphere (%) | Film forming speed (nm/ min) | Specific resistivity (Ω cm) |
|---|---|---|---|---|
| 1 | single | 5 | 20 | 3.2 × 10⁻² |
| 2 | single | 10 | 15 | 4.7 × 10⁻³ |
| 3 | single | 15 | 10 | 1.5 × 10⁶ |
| 4 | dual | 5 | 30 | 5.1 × 10⁻² |
| 5 | dual | 10 | 26 | 3.6 × 10⁻³ |
| 6 | dual | 15 | 17 | 2.3 × 10⁶ |

As shown in TABLE 1, the films were formed efficiently by the reactive sputtering using the IT target, preferably with the dual cathodes.

As described above, according to the first aspect, the ITO thin film can be produced efficiently with low costs by the reactive sputtering using the In/Sn alloy target.

A preferable mode according to the second or later aspects will be described below in detail.

In the method of producing an ITO transparent conductive thin film according to the second aspect, an ITO target containing 6% or less, preferably 1 to 5% of SnO₂ is used when an ITO transparent conductive thin film is formed on a substrate by a sputtering. If the SnO₂ percentage exceeds 6%, the crystalline ITO thin film cannot be formed. From crystallization of the ITO film standpoint, the lower SnO₂ percentage is better. However, the SnO₂ percentage is preferably 1% or more for the reasons that the ITO target having the extremely low SnO₂ percentage is produced with high manufacturing costs under present circumstances, cannot have an increased target density, and deteriorates the conductivity to increase a discharge voltage.

During the sputtering film formation, the substrate is heated to 90 to 170°C, preferably 110 to 160°C, depending on the SnO₂ percentage of the ITO target used. If the temperature is too low, the crystallization cannot be conducted as deposited. If it is too high, the substrate is thermally deteriorated when the substrate made of a polymer material is used.

In the film forming method according to the second aspect, there is no special limitation in the film forming conditions except that the ITO target having the SnO₂ percentage as defined above is used and the substrate is heated to the temperature as defined above. The pressure used for the film formation is preferably within the range of 0.3 to 3.0 Pa in view of subsequent crystallization ease. If the pressure used for the film formation is less than 0.3 Pa, the plasma discharge is difficult to be maintained, and the discharge voltage becomes high to enter high energy particles into the substrate, resulting in a damaged ITO thin film. If the pressure used for the film formation exceeds 3 Pa, the sputter particles are increasingly scattered to lower the film forming speed, and electric resistance of the ITO thin film is increased. The pressure used for the film formation is especially preferably within the range of 0.5 to 2.5 Pa.

The atmosphere gas used for the film formation is preferably comprises Ar and a trace quantity of oxygen, preferably 0.1 to 3% by volume of O₂ introduced based on the total volume of Ar and O₂, which provides the ITO thin film with good transparency and conductivity.

It is not preferable that the atmosphere gas comprise only Ar in view of transparency since the film does not absorb it completely. It is also not preferable that the atmosphere gas comprise greater O₂ than the above-defined range since the resistance value of the resultant ITO thin film is increased.

The ITO thin film may have a non-limiting thickness, for example, 1 nm to 5 µm. The present invention is suitable for forming the ITO thin film having a thickness of 40 nm or less, i.e., 5 to 40 nm, that is difficult to be crystallized as deposited.

Examples of the substrate on which the ITO transparent conductive thin film is formed include a polymer film, a polymer plate, a glass, a metal and the like as described later.

The above-described method of heating the substrate at low temperature for crystallization upon the film formation is suitable when the substrate is a polymer film having low heat resistance. The substrate may be corona treated or plasma treated under vacuum in advance of the film formation in order to improve the tightness of the ITO transparent conductive thin film. In addition, an underlayer for the transparent conductive film may be formed on the substrate in order to improve the tightness of the ITO transparent conductive thin film, as described later.

By the above-mentioned film formation with the sputtering, it is possible to form the crystallized thin film as deposited without requiring annealing after the film formation.

The transparent conductive film according to the fourth aspect comprises a polymer film substrate and an ITO transparent conductive thin film formed thereon by such a method. Specifically, a crystalline ITO transparent conductive thin film is directly formed on the polymer film substrate by the sputtering method.

Examples of a resin material of the polymer film substrate include polyester, polyethylene terephthalate (PET), polybutylene terephthalate, polymethyl methacrylate (PMMA), acryl, polycarbonate (PC), polystyrene, triacetate (TAC), polyvinyl alcohol, polyvinyl chloride, polyvinylidene chloride, polyethylene, ethylene - vinyl acetate copolymer, polyvinyl butyral, metal ion-crosslinked ethylene - methacrylic acid copolymer, polyurethane, cellophane and the like. PET, PC, PMMA and TAC having great strength are preferable, and PET and TAC film are especially preferable.

The polymer film generally has a thickness of about 13 µm to 0.5 mm as used for an upper electrode of a touch panel, but which is change depending on the application of the transparent conductive film. If the thickness of the polymer film is less than 13 µm, the upper electrode does not have sufficient durability. If the thickness exceeds 0.5 mm, the touch panel becomes thick, and the upper electrode undesirably loses flexibility.

If the thickness of the ITO transparent conductive thin film formed on the polymer film is too thin, sufficient conductivity cannot be provided. If the thickness is too thick, the film forming costs are high and optical properties of the transparent conductive film are damaged. Accordingly, the thickness of the ITO transparent conductive thin film is preferably 1 to 500 nm, and more preferably 5 to 40 nm.

It is preferable that the underlayer be formed before the ITO transparent conductive thin film is formed to improve tightness of the ITO transparent conductive thin film. The underlayer may preferably comprise a silicide. Examples of the silicide include SiCₓ, SiOₓ, SiNₓ, SiCₓO_{y}, SiCₓN_{y}, SiOₓN_{y} or SiCₓO_{y}N_{z}. The underlayer may comprise two or more silicide compounds, or may be a laminated film of these silicide compounds.

If the thickness of the underlayer is too thin, the advantages provided by the underlayer cannot be sufficiently provided, i.e., the tightness between the polymer film and the ITO transparent conductive thin film cannot be improved and abrasion resistance cannot be improved. If the thickness of the underlayer is too thick, the tightness and the abrasion resistance are not significantly improved, rather the film forming costs becomes high and the thickness of the transparent conductive film becomes unfavorably thick. Accordingly, the thickness of the underlayer is preferably 0.5 nm to 100 µm, and more preferably 1 nm to 50 µm.

The underlayer can be formed by applying the silicide itself, or a liquid such as a solution dissolved it in a solvent such as alcohol, ketone, toluene and hexane to the polymer film, and drying. The underlayer is formed by a physical deposition method such as vacuum deposition, sputtering and ion plating, or a chemical deposition method such as CVD, preferably by the sputtering, whereby the resultant underlayer becomes dense and is tightly adhered to the polymer film, the film can be formed with less contamination and with high speed, and the ITO transparent conductive thin film can be formed successively within the same apparatus to improve the film formation efficiency.

When the underlayer comprising SiCₓ, SiOₓ, SiNₓ, SiCₓO_{y}, SiCₓN_{y}, SiOₓN_{y} or SiCₓO_{y}N_{z} is formed by the sputtering, Si, SiC, SiO, SiO₂ or Si₃N₄ can be used as the target material. By selecting the type of the reactive gas and controlling the flow rate, the underlayer having the desired composition can be formed.

The sputtering conditions upon the formation of the underlayer are not especially limited. The sputtering can be conducted at vacuum degree of 0.05 to 30 Pa and at an input electric power density of about 2 to 500 kW/m². By controlling the reactive gas flow rate during the sputtering film formation and the time for forming the film, the underlayer having the desired composition and thickness can be formed.

In the transparent conductive film according to the fourth aspect, a hard coat layer may be formed on a surface of the polymer film opposite to the surface on which the ITO transparent conductive thin film is formed. Examples of the hard coat layer include an acryl layer, an epoxy layer, an urethane layer and a silicon layer. The thickness is generally about 0.5 to 20 µm.

When the transparent conductive film according to the fourth aspect is produced, a surface of the polymer film may be plasma-treated through the conventional method before the underlayer is formed on the polymer film. The plasma treatment adds functional groups on the surface of the polymer film to improve the adhesion between the polymer film and the underlayer. In addition, an anchor effect by etching the surface improves the adhesion strength of the underlayer to the polymer film, thereby further improving the peeling resistance. In the transparent conductive film according to the fourth aspect, a cover layer may be further formed on the ITO transparent conductive thin film, thereby further improving the durability.

The touch panel according to the fifth aspect comprises such a transparent conductive film as an upper electrode, as shown in Fig. 1. Since the ITO transparent conductive thin film has good mechanical durability, the touch panel has excellent durability and reliability.

The transparent conductive film according to the fourth aspect is suitable as the upper electrode of the touch panel, but also can be effectively used as other transparent switching device and various optical transparent conductive films.

The following examples and comparative examples illustrate the second to fifth aspects in detail.

In each example, a PET film with a thickness of 188 µm or a slide glass substrate having a UV based curing type acryl hard coat layer formed on one side was used.

### EXAMPLE 7

An Si target and an ITO target containing 3% of SnO₂ were set to a magnetron DC sputtering apparatus, respectively. The above-described PET film was set to a vacuum chamber, which was evacuated to 5 x 10⁻⁴ Pa with a turbo molecular pump. Then, Ar gas and O₂ gas were introduced as a mixture gas thereinto at flow rates of 160 sccm and 40 sccm, respectively to reach 0.5 Pa. Thereafter, 4 kW power was applied to the Si target. An SiO₂ thin film having a thickness of about 50 nm was formed as the underlayer on a surface of the PET film opposite to the surface on which a hard coat layer was formed. The vacuum chamber was again evacuated, and the substrate was heated. While the substrate was held at 130°C, Ar gas and O₂ gas were introduced as a mixture gas thereinto at flow rates of 197 sccm and 3 sccm, respectively to reach 0.5 Pa. Thereafter, 4 kW power was applied to the ITO target. An ITO thin film having a thickness of about 30 nm was formed.

The resultant transparent conductive film was evaluated as follows: The results are shown in TABLE 2.

### <Surface resistivity measurement>

Surface resistivity of the ITO thin film was measured using a surface resistivity meter ("Loresta AP" manufactured by Mitsubishi Chemical Corporaiton).

### <Crystallinity determination>

A diffraction peak was measured using an X-ray diffractometer with a fixed incident angle of 0.5 degree and 2θ scanning to determine crystallinity. Because a peak intensity from (222) plane of the ITO was 500 cps or more, it was determined to a crystal.

### <Slide writing test>

The ITO thin film was faced toward and adhered with an ITO glass substrate having a micro dot spacer. On the hard coat layer of the transparent conductive film, a reciprocal slide writing test was performed using an input pen made of a polyacetal resin (tip 0.8R) with a load of 250 gf. After the test, a linearity value was measured. When the linearity value was 1.5% or less, it was good. When the linearity value exceeds 1.5%, it was poor. The test was performed for the sample before annealing, and for the crystallized sample after annealing, respectively.

### EXAMPLE 8

A film was formed as in EXAMPLE 7 except that an ITO target containing 5% of SnO₂ was used, and the substrate was heated to 160°C. The surface resistivity was measured, the crystallinity was determined, and the slide writing test was performed, and the results are shown in TABLE 2.

### COMPARATIVE EXAMPLE 1

A film was formed as in EXAMPLE 7 except that an ITO target containing 10% of SnO₂ was used, and the substrate was not heated when the ITO thin film was formed. The surface resistivity was measured, the crystallinity was determined, and the slide writing test was performed, and the results are shown in TABLE 2.

### COMPARATIVE EXAMPLE 2

A film was formed as in EXAMPLE 7 except that an ITO target containing 10% of SnO₂ was used. The surface resistivity was measured, the crystallinity was determined, and the slide writing test was performed, and the results are shown in TABLE 2.

### COMPARATIVE EXAMPLE 3

A film was formed as in EXAMPLE 7 except that the substrate was not heated when the ITO thin film was formed. The surface resistivity was measured, the crystallinity was determined, and the slide writing test was performed, and the results are shown in TABLE 2.

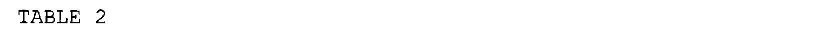

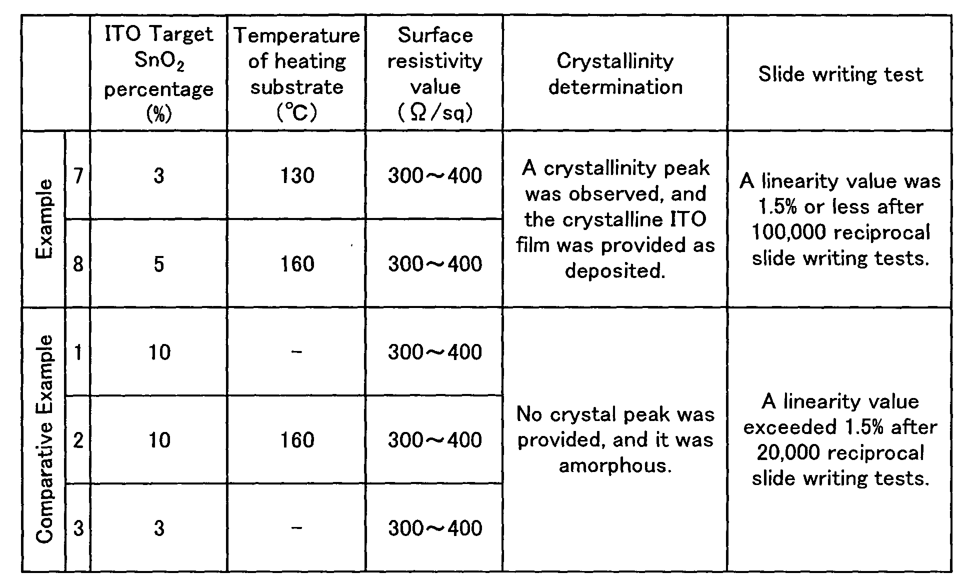

As described above, the ITO film having a thickness of 40 nm or less can be crystallized as deposited by heating the substrate at low temperature when the film is formed by sputtering, which meets heat resistance of the substrate. It is possible to form the crystalline ITO transparent conductive thin film directly by the sputtering to avoid annealing after the film formation, thereby significantly improving the productivity and decreasing the costs. The crystalline ITO transparent conductive thin film can provide a transparent conductive film having excellent mechanical durability. Using such a transparent conductive film, there is provided a touch panel with high durability and reliability.

## Claims

1. A method of producing an ITO thin film, comprising the step of forming the ITO thin film by a reactive sputtering using an In/Sn alloy target.

2. A method of producing an ITO thin film as claimed in Claim 1, wherein an oxygen concentration under sputtering atmosphere is controlled by a plasma emission control.

3. A method of producing an ITO thin film as claimed in Claim 1, wherein an oxygen concentration under sputtering atmosphere is controlled by a plasma impedance control.

4. A method of producing an ITO thin film as claimed in Claim 1, wherein a plurality of cathodes are disposed on which targets are disposed, and wherein a voltage is intermittently applied to each cathode to conduct the reactive sputtering.

5. A method of producing an ITO thin film as claimed in Claim 4, wherein dual cathodes are used, and wherein a voltage is alternately applied to two cathodes disposed adjacent to conduct the reactive sputtering.

6. A method of producing an ITO thin film as claimed in Claim 1, wherein the In/Sn alloy target comprises 50 to 99% by weight of In, and wherein the balance is substantially Sn.

7. An ITO thin film produced by the method as claimed in any one of Claims 1 to 6.

8. A method of producing an ITO transparent conductive thin film on a substrate by a sputtering method, wherein a crystalline ITO transparent conductive thin film is formed by using an ITO target comprising In₂O₃ and SnO₂ where a weight percentage of SnO₂ is 6% or less based on the total weight of In₂O₃ and SnO₂ in the ITO target, and heating the substrate at 90 to 170°C during the sputtering film formation.

9. A method of producing an ITO transparent conductive thin film as claimed in Claim 8, wherein the substrate comprises a polymer material.

10. A method of producing an ITO transparent conductive thin film as claimed in Claim 8, wherein the crystalline ITO transparent conductive thin film has a thickness of 40 nm or less.

11. A method of producing an ITO transparent conductive thin film as claimed in Claim 8, wherein the weight percentage of SnO₂ is 1 to 5% based on the total weight of In₂O₃ and SnO₂ in the ITO target.

12. An ITO transparent conductive thin film on a substrate produced by a sputtering method, which is the crystalline ITO transparent conductive thin film produced by the method as claimed in Claim 8.

13. An ITO transparent conductive thin film as claimed in Claim 12, wherein the substrate comprises a polymer material.

14. An ITO transparent conductive thin film as claimed in Claim 12, wherein the film has a thickness of 40 nm or less.

15. An ITO transparent conductive thin film as claimed in Claim 12, wherein the weight percentage of SnO₂ is 1 to 5% based on the total weight of In₂O₃ and SnO₂ in the ITO target.

16. A transparent conductive film comprising an ITO transparent conductive thin film formed on a polymer film, which is the ITO transparent conductive thin film produced by the method as claimed in Claim 8.

17. A transparent conductive film comprising an ITO transparent conductive thin film formed on a polymer film, which is the ITO transparent conductive thin film as claimed in Claim 12.

18. A transparent conductive film as claimed in Claim 16, an underlayer is disposed between the polymer film and the ITO transparent conductive thin film.

19. A transparent conductive film as claimed in Claim 17, an underlayer is disposed between the polymer film and the ITO transparent conductive thin film.

20. A touch panel comprising the transparent conductive film as claimed in any one of Claims 16 to 19.
